Europäisches Patentamt

European Patent Office

Office européen des brevets

(11) Veröffentlichungsnummer: **0 218 087**

**B1**

(12) **EUROPÄISCHE PATENTSCHRIFT**

(45) Veröffentlichungstag der Patentschrift: **23.01.91**

(21) Anmeldenummer: **86112054.1**

(22) Anmeldetag: **01.09.86**

(51) Int. Cl.⁵: **C 30 B 11/00, C 30 B 29/06, C 30 B 29/60**

(54) Verfahren zum Aufschmelzen und gerichteten Erstarren von Metallen.

(30) Priorität: **10.09.85 DE 3532142**

(43) Veröffentlichungstag der Anmeldung:
**15.04.87 Patentblatt 87/16**

(45) Bekanntmachung des Hinweises auf die
Patenterteilung:
**23.01.91 Patentblatt 91/04**

(84) Benannte Vertragsstaaten:
**CH DE FR GB IT LI NL**

(56) Entgegenhaltungen:
**FR-A-2 056 087**
**US-A-3 376 915**
**US-A-3 886 994**
**US-A-4 086 424**
**US-A-4 243 471**

**PATENT ABSTRACTS OF JAPAN, Band 7, Nr. 185 (C-181)1330r, 13. August 1983; & JP-A-58 91 096 (SUMITOMO DENKI KOGYO K.K.) 30-05-1983**

(73) Patentinhaber: **BAYER AG**
**D-5090 Leverkusen 1 Bayerwerk (DE)**

(72) Erfinder: **Schwirtlich, Ingo, Dr.**
**Hausweberstrasse 26**
**D-4150 Krefeld (DE)**
Erfinder: **Woditsch, Peter, Dr.**
**Deswatinesstrasse 83**
**D-4150 Krefeld 1 (DE)**

EP 0 218 087 B1

# Beschreibung

Die vorliegende Erfindung betrifft ein Verfahren zur Herstellung von kolumnar erstarrten Körpern durch Aufschmelzen von Metallen und deren anschließende Erstarrung in einem Tiegel, wobei an den oberen oder unteren Seite des Tiegels eine höhere Wärmeableitung herrscht als an den anderen Seiten.

Durch die Verknappung und Verteuerung der fossilen Energieträger ist die Suche nach erneuerbaren Energiequellen weltweit verstärkt worden. Dabei wird insbesondere nach Möglichkeiten gesucht, die Sonnenenergie zu nutzen.

Neben den thermischen Energiegewinnungsverfahren ist die direkte Umwandlung der Sonnenenergie in elektrischen Strom mit Hilfe des photovoltaischen Effekts in geeigneten Halbleiten eine vielversprechende Alternative, um den Energiebedarf der Zukunft zu decken.

Solarzellen auf der Basis von Silicium sind heute fast die alleinige Grundlage der Energieversorgung von Satelliten im Weltraum. Das dabei eingesetzte Silicium aus der Halbleitertechnik ist für die terrestrische Energieerzeugung jedoch im allgemeinen zu teuer.

Ein wesentlicher Schritt in der Kette der Kostenreduktionen ist der Ersatz komplizierter Einkristallzüchtungsverfahren durch ein rasches und wirtschaftliches Verfahren der Kristallisation.

In den letzten Jahren hat es nicht an Versuchen gefehlt, kostengünstige Prozesse zu entwickeln, um für Solarzellen geeignetes Silicium herzustellen.

So ist aus der US—A 4 243 471 ein Verfahren bekannt, kristallines Silicium durch gerichtetes Erstarren zu erhalten. Der Ausdehnung des Siliciums beim Übergang vom flüssigen in den festen Zustand um ca. 10% wird in diesem Fall dadurch begegnet, daß man Silicium nach dem Aufschmelzen in einem mittelfrequenzbeheizten Graphitsuszeptor durch langsames Absenken des Tiegels vom Boden her erstarren läßt (Bridgman-Verfahren). Durch den Einsatz einer Kokille, deren Ausdehnungskoeffizient bei $3{,}0—4{,}3 \cdot 10^{-6} °C^{-1}$ liegt, soll sichergestellt sein, daß gerichtet erstarrtes Silicium in diesem Temperaturbereich keinen thermischen Spannungen ausgesetzt wird, die durch Anhaften des Siliciums an der Gefäßwand oder durch den im Vergleich zum Silicium größeren Ausdehnungskoeffizienten entstehen. Dieses Verfahren ist zwar geeignet, bei entsprechendem Aufwand ein Einsetzen der Kristallisation an der Tiegelwand zu vermeiden; es besitzt jedoch den erheblichen Nachteil, daß eine aufwendige und damit teuere Apparatur erforderlich ist und damit eine Erhöhung der Produktion durch den parallelen Betrieb mehrerer solcher Anlagen nicht zu der erwünschten Kostenreduktion führt.

Gemäß der DE—A 3 138 227 wird Silicium in einer Quar gefäß aufgeschmolzen und auf einer Temperatur wenig oberhalb des Schmelzpunktes gehalten. Ein von vornherein am Boden des Schmelzgefäßes angebrachter einkristalliner Siliciumkeim, der durch eine Gaskühlung auf einer Temperatur gehalten wird, die ein Aufschmelzen verhindert, dient hier als Impfkristall. Dadurch wird bewirkt, daß im Verlauf von mehreren Stunden die Kristallisation unter Ausbildung einer konvexen Phasengrenze durch Kühlung des Siliciums von Boden her erfolgt. Nach diesem Verfahren können überwiegend einkristalline Bereiche erhalten werden; außerdem erfolgt eine zusätzliche Reinigung der Siliciumschmelze aufgrund der unterschiedlichen Löslichkeiten der meisten Verunreinigungen in flüssigem und festem Silicium. Der Nachteil dieses sogenannten Wärmetauscherverfahrens besteht in der langsamen Erstarrung des Schmelzvolumens, da die gesamte, beim Silicium sehr hohe Schmelzwärme über die gasgekühlte Si-Einkristallplatte und die geringe Wärmekapazität des Kühlgases abgeführt werden muß. Dies führt bereits bei relativ kleinen Blöcken zu langen Kristallisationszeiten von vielen Stunden. Si-Blöcke von $20 \times 20 \times 10$ cm$^3$ erfordern Kristallisationszeiten von mehreren Tagen.

Die mit der langsamen Kristallisation verbundene Reinigungswirkung aufgrund der Segregationskoeffizienten für Verunreinigungen in Silicium ist allen Verfahren mit einer gerichteten und kontrolliert einstellbaren Kristallisationsgeschwindigkeit gemeinsam.

Gemäß der DE—A 2 745 247 werden Siliciumformkörper mit Kolumnarstruktur durch Eingießen einer Siliciumschmelze in eine Form und Erstarrenlassen der Schmelze erhalten, wobei man die Kontaktfläche der Gießform mit der einen der beiden größten einander gegenüberliegenden Begrenzungsflächen der Schmelze auf einer Temperatur von max. 1200°C hält und die gegenüberliegende Begrenzungsfläche der Schmelze einer 200—1000°C darüberliegenden Temperatur, aber unterhalb des Festpunktes von Silicium, aussetzt. Anschließend erfolgt das Abkühlen der Gußkokille, wobei die Schmelzwärme des Siliciums durch intensive Kühlung des Kokillenbodens abgeführt wird.

Dabei läßt es sich nicht vermeiden, daß durch die Kokillenwände zusätzliche Wärmeverluste auftreten. Die Schmelzwärme wird daher nicht nur über den Kokillenboden, sondern auch über die Seitenwände abgeleitet.

Aufgrund der konkaven Form der Phasengrenze ist eine mechanische Abtrennung der fremdatomreichen Gebiete von denen mit niedriger Konzentration nur unter großen Materialverlusten möglich.

In der DE—A 3 323 896 wird ein Verfahren une eine Vorrichtung zur gerichteten Erstarrung von Schmelzen beansprucht, bei dem die Kristallisationswärme ähnlich wie bei DE—A 3 138 227 über den Kokillenboden ohne Verwendung eines Impfkristalles abgeführt wird. Zur Durchführung dieses Verfahrens sind mehrere Heizungen sowie eine Kühlvorrichtung erforderlich, die einen hohen technischen und wirtschaftlichen Aufwand bedeuten.

Aus der FR—A—2 056 087 geht eine Vorrichtung zum Erstarren von Metallschmelzen hervor, in der eine oder mehrere Kokillen innerhalb eines Suszeptors induktiv über mehrere Spulen erwärmt wird oder werden.

Ziel der vorliegenden Efindung ist es daher, ein einfaches und wirtschaftliches Verfahren zur Verfügung zu stellen, mit dem größere Mengen Silicium aufgeschmolzen werden können und welche nicht die Nachteile der beschriebenen Verfahren aufweisen.

Dies wird erreicht durch ein Verfahren zur Herstellung von kolumnar erstarrten Körpern durch Aufschmelzen von Metallen und deren anschließende Erstarrung in einem Tiegel, wobei an der oberen oder unteren Seite des Tiegels eine höhere Wärmeableitung herrscht als an den anderen Seiten, welches dadurch gekennzeichnet ist, daß durch ein einziges flächenförmiges Widerstands-Heizelement mit mäander- und/oder kammförmiger Abwicklung den senkrecht angeordneten Seiten so viel Wärme zugeführt wird, daß eine Schmelze entsteht und die gerichtete Erstarrung über einen Temperaturgradienten durch Verändern der Heizleistung von Teilen des Heizelementes durch einfaches Umschalten erfolgt.

Bei der Anwendung dieses Verfahrens bleibt die Fläche einer ebenen Fest-flüssig-Phasengrenze während der Kristallization konstant, so daß die Zunahme der Verunreinigungskonzentration pro Flächeneinheit während der fortschreitenden Erstarrung beträchtlich geringer ist als bei Ausbildung einer konkaven Trennfläche zwischen den Gebieten mit hoher und niedriger Verunreinigungskonzentration. Eine mechanische Abtrennung ist daher nur mit geringen Materialverlusten verbunden. Die abgetrennten verunreinigungsreichen Teile können anschließend verworfen oder wieder aufbereitet werden.

Voraussetzung für die Einstellung einer ebenen Festflüssig-Phasengrenze ist ein Temperaturfeld, das durch einen gut orientierten Temperaturgradienten gekennzeichnet ist.

Zum Aufschmelzen der Charge ist dagegen ein homogenes Temperaturfeld erwünscht. Die Temperatur muß oberhalb des Schmelzpunktes des Schmelzgutes liegen.

Das erfindungsgemäße Verfahren ist zum Schmelzen verschiedener Metalle geeignet. Besonders bevorzugt ist es jedoch für Silicium.

Eine besoneres bevorzugte Ausführungsform des erfindungsgemäßen Verfahrens besteht darin, daß das Heizelement zu einer Hohlform gebogen oder aus plattenförmigen Elementen zusammengesetzt ist. Hierdurch ist es möglich, den Kokillenwänden das gewünschte Temperaturfeld aufzuprägen.

Eine Wärmeableitung über die Kokillenwände kann bei dieser Anordnung nur nach unten, zum gekühlten Kokillenboden hin erfolgen. Dadurch wird die vertikale Orientierung des Temperaturgradienten in der Kokille nicht nachteilig beeinflußt.

Die Einstellung eine homogenen Temperaturfeldes, wie es zum Aufschmelzen erforderlich ist, wird durch Verändern der Heizleistung in Teilen des Heizelements bewirkt.

Dadurch können mit einem einzigen Heizelement unterschiedliche Temperaturgradienten eingestellt werden.

Wird indem oberen Teil des Widerstandsheizelementes eine über der Kokillenöffnung angeordnete Widerstandsbahn eingefügt, dann lassen sich bei entsprechend intensiver Bodenkühlung starke Temperaturgradienten einstellen.

Die Abwicklung des Heizelementes weist Mäanderform und oder Kammform auf. Vorzugsweise besteht das Heizelement aus Metallen wie Mo, Ta und Nb oder Graphit oder Siliciumcarbid.

Durch eine externe Schaltung können die zungenförmigen Bahnen zu Widerstandsmäandern unterschiedlichen elektrischen Widerstandes zusammengeschaltet werden. Die Beheizung geschieht dadurch, daß die kammförmigen Einschnitte zu parallelen Strompfaden geschaltet werden.

Die Regelung der Temperatur erfolgt vorzugsweise dadurch, daß durch Umschalten dieser Strompfade die Heizleistung in den betreffenden Teilen des Heizelements beeinflußt und dadurch der Temperaturgradient im Schmelztiegel verändert wird.

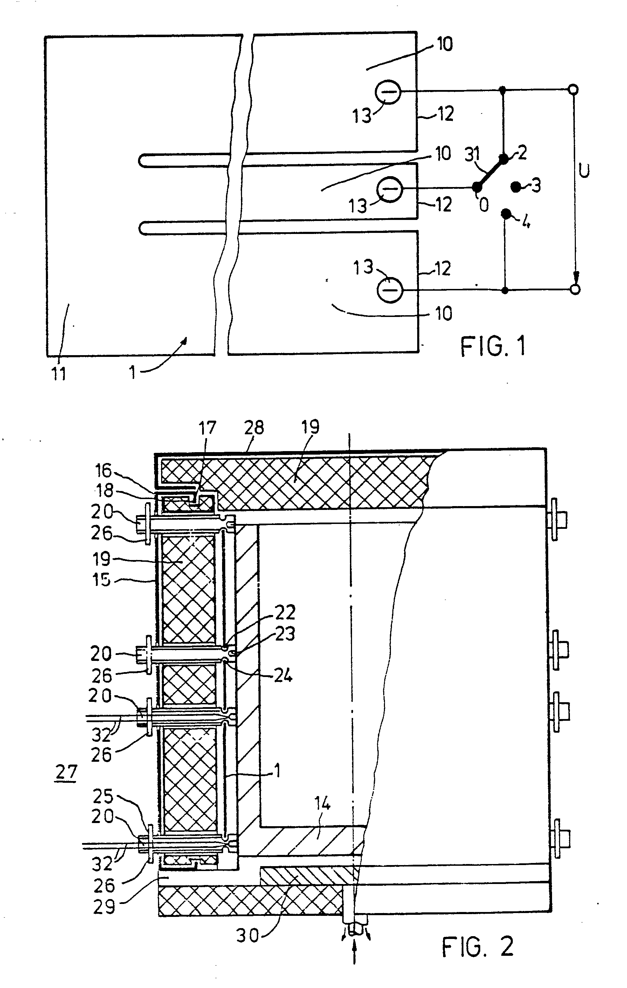

Zur Verdeutlichung dieses Prinzips ist in Fig. 1 eine einfache Version mit 3 Zungen und einer externen Wechselschaltung dargestellt.

Fig. 2 zeigt teilweise im Querschnitt die Vorrichtung mit eingesetzter Kokille.

Im folgenden soll das erfindungsgemäße Verfahren und die Vorrichtung näher beschrieben werden.

Ein Heizelement nach Fig. 1 mit drei Heizbahnen kann z.B. aus einem Mo-Blech von 0,2 mm einfach hergestellt werden. Es besteht aus zungenförmig ausgeschnittenen Leiterbahnen (10), deren Breitenverhältnisse für die Leistungsaufteilung bestimmend sind.

Die einzelnen Zungen sind mit einem Ende untereinander verbunden (11). Die Breite der verbindenden Leiterbahnen wird günstigerweise so gewählt, daß sie mit der breitesten Zunge übereinstimmt.

An den freien Enden der zungenförmigen Leiterbahnen (12) befindet sich eine Bohrung zur Befestigung der Stromanschlüsse (13).

Wie sich gezeigt hat, werden gute Ergebnisse erzielt, wenn die Breitenverhältnisse der 3 Zungen sich wie 1:x:1 mit $0,2 \leq x \leq 0,4$ verhalten.

Das so angefertigte Heizelement wird anschließend zu einer Hohlform entsprechend der Kokillenabmessungen gebogen.

In Fig. 2 ist teilweise im Schnitt die Anordnung des Flächenheizelements (1) um eine quadratische Kokille (14) gezeigt. Um ein gleichmäßiges Temperaturprofil zu gewährleisten, wird der verbindende Teil der Leiterbahnen U-förmig abgebogen.

Für eine mechanisch stabile Anordnung des Heizelements ist eine Stützkonstruktion erfoderlich. Der Schichtenaufbau dieser Stützkonstruktion (27) ist im linken Teil von Abb. 2 dargestellt. Sie besteht aus einem Stahlmantel (15), der auf zwei gegenüberliegenden Seiten zweimal rechtwinklig aufgebogen ist (16), (17). In die dadurch gebildeten Führungsschienen (18) wird die Isolation (19) eingeschoben. Als Isolation kommen Strahlungsschilde oder Fasermatten aus Oxidkeramik oder Graphit in Frage. Das Flächenheizelement wird an diesem Körper durch hohle Keramikstifte (20) gehalten, die an der den Heizer (1) tragenden Seite drei Einschnitte (22), (23), (24) besitzten. Einschnitt (22) und (24) bilden zwei parallele Sehnen mit gleichem Abstand von der Stiftachse. Der dritte Einschnitt (23) ist an der Stirnseite des Stiftes angebracht.

Die gegenüberliegende Seite des Hohlstifts ist mit zwei Schlitzen (25) versehen, die zwei um 90° gegenüber (22), (24) versetzte zueinander parallele Sehnen mit gleichem Abstand zur Achse des Stiftes bilden. In diese Schlitze greift ein U-förmiges Blechstück (26) ein, das Stift (20) am Herausgleiten hindert. Die Stützkonstruktion mit Flächenheizelement (1) kann so ausgeführt werden, daß sie sich um die Kokille herumklappen läßt. Dies erreicht man bei rechteckigen Kokillen durch eine vierteilige Ausführung der Stützkonstruktion. Dabei sind die einzelnen Teile untereinander durch Scharniere verbunden. Bei runden Kokillen wählt man zweckmäßigerweise eine Konstruktion, die aus zwei Halbschalen besteht.

In die Halterung (27) mit dem Flächenheizelement (1) wird die Kokille (14) mit dem Schmelzgut hineingestellt.

Um eine Wärmeabstrahlung nach oben zu verhindern, wird ein isolierender Deckel (28) aufgesetzt.

Die Kokille steht auf einer Unterlage (29) die durch die Wahl ihres Materials und ihrer Dicke die Wärmeleitung nach unten zu einer gekühlten Metallplatte (30) bestimmt. Für die Unterlage (29) kommen keramische Materialien, wie z.B. Aluminiumoxid, Mullit oder Siliciumnitrid, wie auch Graphit in Form von Fasermaterial oder kompakt in Frage. Stärke und Material der Unterlage müssen mit der Geometrie, d.h. den Heizleistungsverhältnissen der einzelnen Leitungsbahnen, des Heizleiters abgestimmt werden.

Zum Aufschmelzen einer Charge grobkörnigen Siliciums wird der Schalter (31) in Fig. 1 auf Position (2) geschaltet. Dadurch wird im untersten Teil eine höhere Temperatur als in den beiden oberen Bahnen erreicht. Die Kühlung der Metallplatte (30) wird in dieser Phase des Verfahrens zum Zwecke der Energieeinsparung reduziert bzw. ausgeschaltet. Durch die höhere Heizleistung des unteren Teils des Flächenheizers wird die restliche Wärmeableitung kompensiert. In diesem Zustand erhält man in der Kokille ein homogenes Temperaturfeld, das die Charge nach Erreichen des Schmelzpunktes zum Aufschmelzen bringt. Bei sehr geringen Wärmeverlusten kann durch Schalten auf Pos. (3) direkt ein homogenes Temperaturfeld erzeugt werden.

Zur Einleitung der gerichteten Erstarrung muß den Kokillenwänden ein Temperaturgradient aufgeprägt werden. Dazu wird die Bodenplatte (30) gekühlt und der Schalter (31) in Fig. 1 auf Pos. (4) geschaltet. Dadurch werden die beiden unter Leiterbahnen des Heizelements parallel geschaltet, so daß die obere Heizungsbahn heißer und die beiden unteren kühler werden. Aufgrund der elektrisch symmetrischen Auslegung dieses Heizelements bleibt die Gesamtleistung, von einer Übergangsphase während des Schaltzietpunktes abgesehen, konstant.

Durch Thermoelemente (32), die zweckmäßigerweise durch die Befestigungsröhrchen (20) hindurchgeschoben werden, kann die Temperatur der Kokillenwand an verschiedenen Stellen gemessen werden.

Aus der Temperaturänderung beim Passieren der Festflüssig-Phasengrenze kann die Erstarrungsgeschwindigkeit ermittelt werden.

Nach Erstarren der Charge wird die Kühlleistung der Bodenplatte wieder reduziert, der Schalter (31) in Position (2) geschaltet, so daß sich wieder eine homogenes Temperaturfeld einstellt. Anschließend wird die Heizleistung reduziert und der Gesamtblock abgekühlt.

Bei dieser Verfahrensweise erhält man kolumnar erstarrte Blöcke mit sehr gut ausgerichteten Kristallkörnern von mehreren Zentimetern Länge bei einer Breite von ca. 1 cm, wie sie sich bei der Ausbildung einer ebenen Fest-flüssig-Phasengrenze ergeben. Durch eine geeignete Wahl der Abkühlgeschwindigkeit wird die Bildung innerer Spannungen vermieden. Durch die Kontrolle der Erstarrungsgeschwindigkeit ist es möglich, sie über eine Veränderung der Heizleistung zu beeinflussen, so daß sie zur Vermeidung der Rückdiffusion von Verunreinigungen, die vor der Phasengrenze transportiert werden, optimiert werden kann.

Das an der relativ einfachen Ausführung des Flächenheizers nach Fig. 1 erläuterte Verfahren kann durch die Verwendung optimierter Heizergeometrien verbessert werden.

So ist ein Flächenheizer denkbar, dessen im wesentlichen mäanderförmige Widerstandsbahn durch weitere kammförmige Einschnitte unterteilt ist, so daß vielfältige Möglichkeiten zur Einstellung geeigneter Temperaturgradienten bestehen. Durch einen zusätzlich angeordneten Widerstandsmäander in der obersten Leitungsbahn, der über die Kokillenöffnung geklappt werden kann, ist eine Verstärkung des Temperaturgradienten erreichbar. Die Ausführungsform ist vor allem bei großen Kokillen sinnvoll, um Wärmeverluste durch die obere Kokillenisolierung zu kompensieren.

Durch zeitlich koordiniertes Parallelschalten der einzelnen Leiterbahnen kann der Temperaturgradient zeitlich variiert werden, so daß eine Anpassung der Erstarrungsgeschwindigkeit an unterschiedliche Kokillenquerschnitte möglich ist.

Bisher wurde der Aufbau und die Funktion der erfindungsgemäßen Vorrichtung unter Zugrundelegung eines Flächenheizers, der aus einem Widerstandsblech gefertigt war, erläutert.

Bei der Verwendung von Graphitfolien gilt entsprechendes. Allerdings ist hier die höhere Knickempfindlichkeit der Folie bei der Gestaltung der Kokollenform zu berücksichtigen.

Erfindungsgemäß können auch Graphitplatten als Material für das Heizelement eingesetzt werden. Hier sind allerdings Verbindungen der einzelnen Leiterbahnteilstücke untereinander nötig. Wie sich gezeigt hat, gelingen diese Verbindungen unter Verwendung von handelsüblichen Graphitklebern. Dabei muß jedoch die Querschnittsfläche an der Klebestelle erhöht werden, um den höheren Flächenwiderstand der Verbindungsstelle zu kompensieren. Durch eine geeignet dimensionierte Verstärkung ist dieses Problem für den Fachmann leicht lösbar.

Die im folgenden aufgeführten Beispiele sollen das erfindungsgemäße Verfahren und die Vorrichtung erläutern, ohne eine Einschränkung des Erfindungsgedankens darzustellen.

Beispiel 1

Aus einem 0,2 mm dicken gewahlten Mo-Blech wurde entsprechend Fig. 1 ein Heizelement angefertigt, dessen obere und untere Leiterbahn jeweils 74 mm breit waren, während die mittlere Leiterbahn eine Breite von 22 mm aufwies. Die Schlitzbreite zwischen den Bahnen betrug 5 mm.

Mit dieser Anordnung kann bei Parallelschaltung einer äußeren mit der mittleren Leiterbahn ein Heizleistungsverhältnis von 96/74=1,30 eingestellt werden. Diese Heizelement wurde zu einer Hohlform gebogen und in einer Stützkonstruktion entsprechend Fig. 2 befestigt. Dadurch wird die gesamte Vorrichtung zu einer selbstragenden Einheit mit einer lichten Weite von 150 mm im Quadrat. In den Hohlraum wurde eine mit Siliciumgranulat gefüllte Kokille mit einer Grundfläche von ca. 120 mm×120 mm eingesetzt. Die gesamte Anordnung wurde unter Zwischenlegen einer 5-mm-Graphitfilzmatte auf eine wassergekühlte Metallplatte gestellt. Von oben wurde die Vorrichtung mit einer 30 mm dicken Hartfilzplatte unter Zwischenlegen einer 5-mm-Graphitplatte, die von einem Metallmantel gehalten wurden, gegen Wärmeverluste isoliert. Die gleiche Art der Isolation wurde bei den Seitenwänden der Stützkonstruktion verwendet. Das Heizelement wurde durch entsprechend lang gewählte Keramikstifte so befestigt, daß kein elektrischer Kontakt zur Isolierung vorhanden war.

Die gesamte Anordnung wurde in einer Argonatmosphäre bei Schalterposition (2) (in Fig. 1) mittels Stromdurchgang durch das Flächenheizelement erhitzt. Die Temperaturen wurden durch EL 18-Thermoelemente, die in die hohlen Keramikstifte eingeführt waren, gemessen. Bei Erreichen des Schmelzpunkte von Silicium (1420°C) betrug der Temperaturunterschied über die Kokillenhöhe ca. 10°C.

Nach Aufschmelzen der Charge wurde der elektrische Schalter auf Pos. (4) geschaltet. Dadurch wird die Heizleistung im unteren Teil der Kokille reduziert. Durch die Wärmeableitung über die gekühlte Metallplatte erstarrt die Schmelze von unten nach oben. Der Durchgang der Erstarrungsfront konnte an der Tempraturänderung der Thermoelement verfolgt werden. Die gesamte Charge war nach ca. 1,5 h vollständig erstarrt, so daß die gesamte Heizleistung reduziert werden konnte. Die Abkühlung auf Raumtemperatur erfolgte mit durchschnittlich 200°C/h.

Der Kokille wurde anschließend ein Si-Block mit vertikaler Orientierung der Kristallkörner entnommen. Die Körner waren durchschnittlich 50 mm lang bei einem Durchmesser von 6—10 mm. Aus der ebenen Grenzfläche zwischen verunreinigungsreichen und verunreinigungsarmen Bereichen im obersten Teil des Blocks infolge der Segregationswirkung kann man auf eine ebene Phasengrenzfläche bei der Erstarrung schließen.

Beispiel 2

Entsprechend Fig. 1 wurden aus Graphitplatten mit einer Stärke von 5 mm vierteilige Leiterbahnen von 74 mm und 22 mm Breite angefertigt. Die Längen wurden so bestimmt, daß durch Zusammensetzen eine quadratische Hohlform von ca. 150 mm lichter Weite gebildet wurde. Diejenigen Leiterstücke, an denen die Stromzuführungen befestigt wurden, wurden um 70 mm länger ausgelegt. Die Verbindung der eine Widerstandsbahn bildenden Heizleiterelemente erfolgte durch Klebungen mit Unterstützung eines Graphitwinkelstücks, das auf eine Länge von 15 mm den Querschnitt verdoppelte. Die drei Widerstandsbahnen mit dem kammförmigen Verbindungsstück wurden durhc Keramikstifte wie in Fig. 2 auf Abstand gehalten. Zur Einstellung eines Gesamtwiderstandes von ca. 120 m Ω waren zusätzliche Einschnitte in den einzelnen Leiterbahnen senkrecht zum Stromfluß erforderlich.

Mit dieser Anordnung wurde wie in Beispiel 1 in einer Argonatmosphäre Silicium aufgeschmolzen und anschließend gerichtet erstarrt. Man erhielt einen grobkristallinen kolumnaren Si-Block mit auch im Randbereich gut ausgerichteten Kristallkörnern.

**Patentansprüche**

1. Verfahren zur Herstellung von kolumnar erstarrten Körpern durch Aufschmelzen von Metallen und deren anschließende Erstarrung in einem Tiegel, wobei an der oberen oder unteren Seite des Tiegels eine höhere Wärmeableitung herrscht als an den anderen Seiten, dadurch gekennzeichnet, daß durch ein einziges flächenförmiges Widerstands-Heizelement mit mäander- und/oder kammförmiger Abwicklung den senkrecht angeordneten Seiten so viel Wärme zugeführt wird, daß eine Schmelze entsteht und die gerichtete Erstarrung über einen Temperaturgradienten durch Verändern der Heizleistung von Teilen des Heizelementes durch einfaches Umschalten erfolgt.

2. Verfahren gemäß Anspruch 1, dadurch gekennzeichnet, daß das Metall Silicium ist.

3. Verfahren gemäß der Ansprüche 1 oder 2, dadurch gekennzeichnet, daß das Heizelement zu einer Hohlform gebogen und/oder aus plattenförmigen Elementen zusammengesetzt ist.

4. Verfahren gemäß einem oder mehrerer der Ansprüche 1 bis 3, dadurch gekennzeichnet, daß das Heizelement aus Metallen wie Mo, Ta und Nb oder Graphit oder Siliciumcarbid besteht.

5. Verfahren gemäß einem oder mehreren der Ansprüche 1 bis 4, dadurch gekennzeichnet, daß die kammförmigen Einschnitte zu parallelen Strompfaden geschaltet werden.

6. Verfahren gemäß anspruch 5, dadurch gekennzeichnet, daß durch Umschalten dieser Strompfade die Heizleistung in den betreffenden Teilen des Heizelements beeinflußt und dadurch der Temperaturgradient im Schmelztiegel verändert wird.

**Revendications**

1. Procédé de production de corps à solidification columnaire par fusion de métaux puis solidification dans un creuset, dans lequel il règne à la partie supérieure ou à la partie inférieure du creuset une plus grande dissipation de chaleur que sur les autres côtés, caractérisé en ce qu'on fait arriver aux côtés disposés verticalement, par un unique élément chauffant à résistance de forme plane à développement en méandres et/ou en peigne, une quantité suffisante de chaleur pour qu'une masse fondue soit produite et pour que la solidification orientée s'effectue selon un gradient de température par variation de la puissance calorifique de parties de l'élément chauffant par simple commutation.

2. Procédé suivant la revendication 1, caractérisé en ce que le métal est le silicium.

3. Procédé suivant l'une des revendications 1 et 2, caractérisé en ce que l'élément chauffant est recourbé selon une forme creuse et/ou est composé d'éléments en plaques.

4. Procédé suivant une ou plusieurs des revendications 1 à 3, caractérisé en ce que l'élément chauffant est constitué en métaux tels que Mo, Ta et Nb ou en graphite ou en carbure de silicium.

5. Procédé suivant une ou plusieurs des revendications 1 à 4, caractérisé en ce que les entailles en peigne sont montées en trajets de courants parallèles.

6. Procédé suivant la revendication 5, caractérisé en ce que la puissance calorifique est influencée dans les parties concernées de l'élément chauffant par commutation de ces trajets de courants et le gradient de température dans le creuset de fusion est ainsi modifié.

**Claims**

1. Process for manufacturing columnar solidified elements by melting open metals and subsequently solidifying them in a crucible, with there being a higher heat dissipation at the top or bottom of the crucible than at the sides, characterised in that sufficient heat is supplied through a single laminar resistance heating element of a meander- and/or comb-like development to the vertically disposed sides to produce a melt, and directional solidification is effected by means of a temperature gradient by varying the heating capacity of parts of the heating element by simple changeover.

2. Process according to claim 1, characterised in that the metal is silicon.

3. Process according to one of claims 1 or 2, characterised in that the heating element is bent into a hollow shape and/or is made up of platelike elements.

4. Process according to one or several of claims 1 to 3, characterised in that the heating element is made from metals such as Mo, Ta and Nb or graphite or silicon carbide.

5. Process according to one or several of claims 1 to 4, charactered in that the comb-like indentations are connected to form parallel current paths.

6. Process according to claim 5, characterised in that by changing over these current paths the heating capacity in the relevant parts of the heating element is influenced and consequently the temperature gradient in the melting crucible is varied.

EP 0 218 087 B1

FIG. 1

FIG. 2